# EUROPEAN PATENT APPLICATION

(11) **EP 2 688 201 A1**
(43) Date of publication of application: **22.01.2014**
(21) Application number: 12305871.1
(22) Date of filing: 18.07.2012
(51) Int. Cl.: H03F 1/02, H03F 3/24

(54) **A controller and a method for controlling an operating characteristic of an amplifier circuit**

(71) Applicant: Alcatel Lucent, 75007 Paris (FR)
(72) Inventor: Machinal, Robin, 70197 Stuttgart (DE); Bitzer, Thomas, 73614 Schorndorf (DE)
(74) Representative: 2SPL Patentanwälte

(57) **Abstract**

A controller (2) for controlling an operating characteristic of an amplifier circuit (4) comprising at least a first amplifier (6) and a second amplifier (8) coupled to an output (10) of the first amplifier (6), wherein the first amplifier (6) is powered from a first power supply (12) by a first energy supply signal (14) and the second amplifier (8) is powered from a second power supply (16) by a second energy supply signal (18). The controller comprises a monitoring interface (20) operable to receive monitoring information indicative of a signal characteristic of a signal amplified by the amplifier circuit and a control interface (22) operable to provide a control signal (24) being operable to modify at least one of the group of the first energy supply signal (14) and the second energy supply signal (18) such that a power efficiency of the amplifier circuit (4) is increased.

## Description

Embodiments of the present invention relate to a controller and a method for controlling an operating characteristic of an amplifier circuit, in particular of an amplifier circuit comprising at least a first amplifier and a second amplifier coupled to an output of the first amplifier.

### Background

Applications utilizing at least two amplifiers in an amplifier chain are numerous. Generally, amplifier chains are often used when a low-power signal is to be amplified to a signal with considerable power or energy. To this end, amplifiers are connected in series such that a second amplifier is coupled to an output of a first amplifier. The signal already pre-amplified by the first amplifier serves as an input to the second amplifier which amplifies the pre- amplified signal further so that the individual gains of the amplifiers multiply. Depending on the individual gains and the number of amplifiers in the chain, signals with a considerable power, that is signals containing a significant energy can be provided.

One example for the use of amplifier chains are the so-called RF-pallets used in base stations of a mobile communication system in order to amplify the low power radio frequency signal before transmission of the same via antennas in order to communicate with various types of user equipment (UE). The mobile communication system may, for example, correspond to one of the mobile communication systems standardized by the 3rd Generation Partnership Project (3GPP), as Global System for Mobile Communications (GSM), Enhanced Data rates for GSM Evolution (EDGE), GSM EDGE Radio Access Network (GERAN), Universal Terrestrial Radio Access Network (UTRAN) or Evolved UTRAN (E-UTRAN), e.g. Universal Mobile Telecommunication System (UMTS), Long Term Evolution (LTE) or LTE-Advanced (LTE-A), or mobile communication systems with different standards, e.g. Multistandard Radio (MSR), Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Code Division Multiple Access (CDMA), Orthogonal Frequency Division Multiple Access (OFDMA) or any other technology with a multiplexing capable physical layer like Filter Bank Based Multicarrier (FBMC) systems.

In the following the terms mobile communication system and mobile communication network are used synonymously. The mobile communication system may comprise mobile transceivers and base station transceivers. A mobile transceiver may correspond to a smartphone, a cell phone, user equipment, a laptop, a notebook, a personal computer, a Personal Digital Assistant (PDA), a Universal Serial Bus (USB) -stick, a car, etc. A mobile transceiver may also be referred to as User Equipment (UE) in line with the 3GPP terminology. A base station transceiver can be located in the fixed or stationary part of the network or system. A base station transceiver may correspond to a remote radio head, a transmission point, an access point, a macro cell, a small cell, a micro cell, a femto cell, a metro cell etc. A base station transceiver can be a wireless interface of a wired network, which enables transmission of radio signals or radio frequency signals to a UE or mobile transceiver. Such a radio signal may comply with radio signals as, for example, standardized by 3GPP or, generally, in line with one or more of the above listed systems. Thus, a base station transceiver may correspond to a NodeB, an eNodeB, a BTS, an access point, a remote radio head, a transmission point etc., which may be further subdivided in a remote unit and a central unit.

Base station transceivers for such a base station of a mobile communications system typically comprise an amplifier circuit having two or more amplifiers connected in series such as to provide for the possibility of amplifying the radio frequency signal to the required extent.

In order to provide for the required maximum gain of the RF-pallet, the relative gains of the individual amplifiers may be predetermined, that is, the contribution of each amplifier to the resultant overall gain may be fixed, while the overall gain of the RF-pallet may be variable in order to, for example, provide different areas of coverage for different base station transceivers.

While different output powers may be provided by conventional RF-pallet systems, the power efficiency, which is the ratio between the RF power of the signal as provided by the RF-pallet and the power required to provide that signal, may be low. This may particularly be the case when a signal characteristic of the signal amplified by the amplifier or the RF-pallet changes significantly with time. For example, when the dynamic range of the signal changes, e.g. the peak to average ratio of the amplitude or the power of the signal, the power efficiency of the RF-pallet may decrease significantly, since the operation of the amplifiers or the operating point of the power supplies serving to supply the amplifiers with the required energy may be shifted to an inefficient regime. That is, a power efficiency of an amplifier circuit may not only be degraded due to the decreasing efficiency of the individual amplifiers themselves but also due to a decrease of a power efficiency of the power supplies that power the amplifiers by an energy supply signal.

In the event of signals having signal characteristics changing significantly, the RF-pallet or the whole system may, therefore, work inefficiently and thus consume an unnecessary amount of power. This may result in unnecessarily high operation costs for the RF-pallet. In particular in mobile telecommunication systems where numerous base station transceivers are equipped with RF-pallets, this may sum up to quite a considerable amount of wasted energy and money. However, this behavior does also impose technical problems since the dissipated energy or heat produced by the RF-pallets operated in modes of low power efficiency needs to be transported away from the RF-pallet reliably in order to avoid overheating and technical failure of the whole system.

Therefore, the need exists to provide alternative ways as to how to operate amplifier circuits comprising at least a first amplifier and a second amplifier connected in series with the first amplifier.

### Summary

According to some embodiments of the present invention, this is achieved by a controller and a method for controlling an operating characteristic of an amplifier circuit which comprises at least a first amplifier and a second amplifier coupled to an output of the first amplifier such as to build an amplifier chain, wherein the first amplifier is powered from a first power supply by a first energy supply signal and a second amplifier is powered from a second power supply by a second energy supply signal. The controller comprises a monitoring interface operable to receive monitoring information indicative of a signal characteristic of a signal amplified by the amplifier circuit. The controller further comprises a control interface operable to provide a control signal depending on the monitoring information, the control signal being operable to modify a characteristic of at least one energy supply signal of the first or the second energy supply signal such that a power efficiency of the amplifier circuit is increased.

That is, embodiments of controllers for controlling an operating characteristic of an amplifier circuit use information on a signal characteristic of a signal amplified by the amplifier circuit to dynamically adapt the mode of operation of the power supplies, that is to change the energy supply signals provided by the power supplies. To this end, the operating characteristics or the operating point of the individual amplifiers and/or their associated power supplies may be changed such that a power efficiency of the amplifier circuit is increased. The particular power efficiency increased may, for example, be the power efficiency of individual power supplies, which may in some implementations be the component of the amplifier circuit that contributes the most to the energy losses of the system. That is, modifying the characteristic of one or more energy supplies such that their individual energy losses or dissipation losses become minimal may provide for an optimal solution in the sense that an overall energy efficiency of the amplifier circuit is increased or even maximized for the given signal conditions.

Alternatively or additionally, the power efficiency that is increased by the modification of the characteristic of the at least one energy supply signal may be an individual power efficiency of one of the amplifiers. In those embodiments, overheating, damage or aging effects of an individual amplifier may be avoided by the controller. Generally speaking, a power efficiency which is increased by the modification of the characteristic of the at least one energy supply signal may be a power efficiency of individual devices or a combined power efficiency of an arbitrary combination of devices of the amplifier circuit. As elaborated on previously, this may also mean that an overall power efficiency of the complete amplifier circuit is increased or, depending on the implementation details, that a combined power efficiency of all power supplies or of all amplifiers is increased.

A signal characteristic of a signal amplified by the amplifier circuit may be any signal characteristic that allows concluding on the operational states of individual devices of the amplifier circuit or of an arbitrary combination of those. For example, the information indicative of the signal characteristic may be derived from the signal to be amplified directly, for example as a peak to average ratio (PAR) of the amplitude or the power of the signal. This information may give a hint to the required dynamic range of the amplifiers of the amplifier circuit or the RF-pallet. To this end, the signal analyzed may be the signal provided to the amplifier circuit, the signal within the amplifier chain at an output of the first amplifier or an output signal of the amplifier circuit.

A monitoring information indicative of a signal characteristic of the signal amplified by the amplifier circuit may, apart from particular characteristics as derived from the signal itself, be any further kind of information which allows to implicitly conclude on the operating point of all or individual devices of the amplifier circuit and hence on a signal characteristic of the amplified signal. This may, for example, also be a current or a voltage drawn from or provided by one or all power supplies, a gain factor of one individual or an arbitrary combination of amplifiers of the amplifier circuit, a total output power of the signal as generated by the amplifier circuit or the like.

Depending on the particular implementation, a high mean modulation amplitude, which may at a given supply voltage or maximum possible modulation amplitude correspond to a low PAR, may correspond to an efficient mode of operation of a power supply or an associated amplifier. Hence, a high PAR may result in the opposite.

The controller, however, may account for the individual signal characteristics of the signal to be amplified in that the operating point of individual or all amplifiers and/or of individual or all power supplies is modified such as to achieve an increase in the power efficiency of individual or all devices.

In that sense, the control signal operable to modify a characteristic of at least one energy supply signal may be understood as a control signal that makes or programs the individual power supplies such as to modify the characteristic of the energy supply signal provided or generated by the respective power supply. For example, the control signal may be operable to cause a change of a level of a constant supply voltage or of a constant supply current at an output of a power supply.

According to some embodiments of the present invention, the control signal is provided such that a combined power efficiency of the first and the second power supply is increased. That is, not only the dissipation losses or individual power efficiencies of the associated amplifiers of the amplifier chain may be considered but also the power efficiency of the associated power supplies, which may, as for example in some RF-pallets, contribute the most to the overall energy loss.

According to some embodiments of the present invention, the control signal is also provided such that a power of an output signal provided by the amplifier circuit is maintained. That is, a power efficiency of the signal generation within the amplifier circuit may be increased without negatively affecting the output power as provided by the amplifier circuit.

To this end, the control signal is, according to some embodiments, operable to modify a voltage or a current of the at least one energy supply signal such that the power supplies or at least one of the power supplies of an amplifier circuit is operated in a first operating range where the power supply has a higher power efficiency than in a second operation range in which the operating point of the power supply was before the modification of the mode of operation of the power supply by the control signal.

According to some embodiments of the present invention, the control signal is provided such that the energy supply signals are modified such that one of the power supplies operates in a first operation range where it has a high power efficiency whereas the other one of the power supplies operates in a second operating range where it has a low power efficiency, albeit increasing a combined power efficiency of both power supplies.

For example, the second power supply associated to the second amplifier receiving the pre-amplified signal of the first amplifier may be scheduled to be operated in the efficient mode of operation since the power supply provides a higher amount of energy to the second amplifier that resides in the output stage of the amplifier chain. Therefore, the first power supply associated to the first amplifier may be operated in a less efficient mode of operation while a total power efficiency of the amplifier circuit is nonetheless increased.

According to some embodiments using power supplies providing a constant supply voltage as an energy supply signal, the voltage as provided by the first power supply signal may be lowered while the voltage as provided by the second power supply signal may be increased. In embodiments where constant supply voltages are provided by the power supplies and where transistors are utilized as amplifier stages, the power efficiency of the individual power supplies may, for example, be dependent on the current drawn from the power supply. Generally speaking, the operation ranges corresponding to high power efficiency and to low power efficiency may depend on a further characteristic of the energy supply signals. A low current may mean that the power supply is operated in an inefficient mode of operation, while a high current drawn from the voltage supply may make the power supply operate in an efficient mode of operation.

According to some embodiments of the present invention, an amplifier circuit and a controller according to one of the embodiments is implemented within a base station transceiver of a mobile communications system such as to amplify the radio frequency signal before it is provided to transmit antennas. In a mobile communications system, the signal characteristic of the signal to be amplified may change significantly and thus cause conventional RF pallets to operate with low average power efficiency. In particular, the signal processing in mobile communications systems may lead to a repeated decrease of the peak to average ratio of a radio frequency signal to be amplified, thus making amplifiers and their driving power supplies operate in an operation range with low power efficiency. This may be the case when the number of user equipment, communications or radio channels served by the particular base station decreases such that only fewer signals or channels are superimposed before the amplification which, in turn, leads to a decrease of the signal to average ratio. The same will be the case when channel conditions deteriorate such that a lower order modulation scheme is used for the established radio channels.

According to some embodiments, therefore, the control signal may be provided depending on the amount of data or traffic sent by the base station via the signal amplified by the amplifier circuit without an in depth analysis of the RF signal itself. That is the control signal may be provided such as to increase the overall power efficiency of the amplifier circuit without the need to sense the condition of individual devices or of signal parameters within the amplifier circuit itself. The information on the amount of data sent by the base station may, for example, be gathered with low effort from the protocol layers of the telecommunications system, such as for example utilizing the knowledge on the modulation scheme presently used or on the knowledge of the total amount of data or the data rate of the data presently sent via the particular base station.

According to some embodiments, digitally controllable voltage converters are used as power supplies in a circuit utilizing transistors (such as, for example, field effect transistors or bipolar transistors of N-channel or P-channel type) as amplifiers. With digitally controllable voltage converters the implementation may be achieved without any significant hardware overhead by calculating the required control signals in order to program the digitally controllable voltage converters such as to change their output voltages while the same are in operation. This may, for example, be achieved by means of a Field Programmable Gate Array (FPGA).

Hence, some embodiments comprise a digital control circuit installed within the apparatus or controller for performing the method. Such a digital control circuit, e.g. a digital signal processor (DSP) or a FPGA, needs to be programmed accordingly. Therefore, yet further embodiments also provide a computer program having a program code for performing embodiments of the method, when the computer program is executed on a computer or a digital processor.

### Brief description of the Figures

Some embodiments of apparatuses and/or methods will be described in the following by way of example only, and with reference to the accompanying figures, in which
- Fig. 1: shows an embodiment of a controller for controlling an operating characteristic of an amplifier circuit;
- Fig. 2: shows an example for a first operating range having associated thereto a higher power efficiency and a second operation range having associated thereto a lower power efficiency for different types of power supplies;
- Fig. 3: shows a further embodiment of a controller for controlling an operating characteristic of an amplifier circuit;
- Fig. 4: schematically shows an embodiment of a method for controlling an operating characteristic of an amplifier circuit; and
- Fig. 5: schematically shows a base station transceiver being part of a base station of a mobile communications system, wherein the base station transceiver comprises an embodiment of a controller for controlling an operating characteristic of an amplifier circuit or executes a corresponding method.

### Description of Embodiments

Various embodiments will now be described with reference to the accompanying figures in which only some exemplary embodiments are illustrated. For the sake of clarity, individual components, lines, layers and/or regions within the figures may not be drawn to scale.

It should be understood, however, that there is no intent to limit further embodiments to the particular implementations disclosed in the following figures. To the contrary, it is pointed out that further embodiments may use alternative implementations or modifications and equivalents of the implementations disclosed in the figures which fall within the scope of the invention. In particular, the fact that individual functionalities are described with respect to different entities, functional blocks or devices shall not be construed to mean that those entities are physically separated in all possible further embodiments of the present invention. Further embodiments may also unite several functionalities in a single entity, functional block or device. Also, multiple functionalities described with respect to one single entity, functional block or device may be distributed over multiple physically separated components in further embodiments or implementations.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (*e.g*., "between" versus "directly between," "adjacent" versus "directly adjacent," etc.).

The terminology used herein is for the purpose of describing particular embodiments only and is not intended to be limiting further embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein shall have the same meaning as commonly understood by one of ordinary skill in the particular art.

Like reference numbers refer to like or similar elements throughout the following description of the figures.

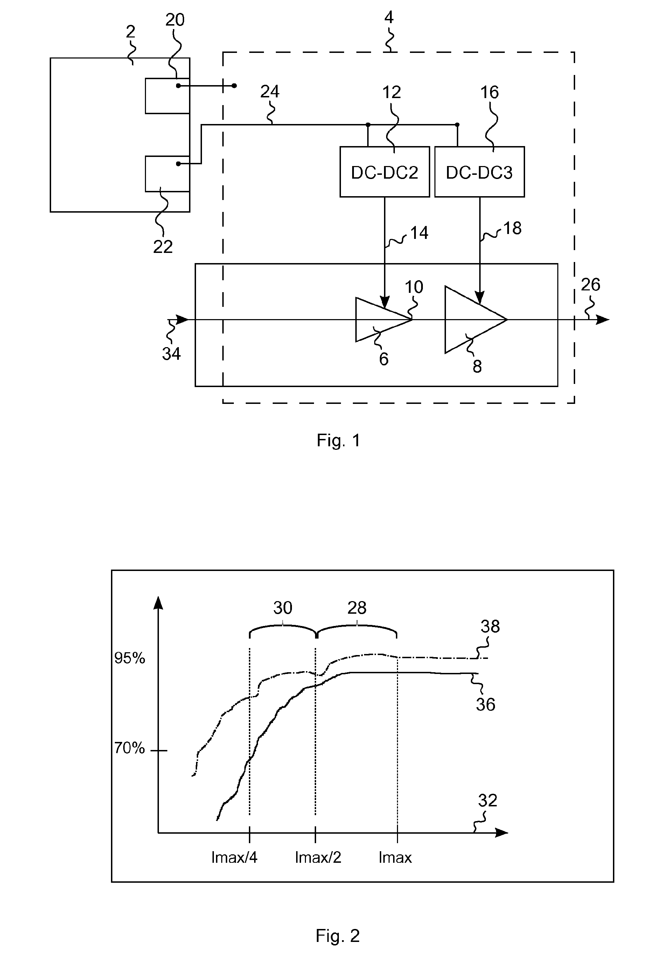

Fig. 1 shows a principle sketch of an embodiment of a controller 2 for controlling an operating characteristic of an amplifier circuit 4. The amplifier circuit 4 comprises at least a first amplifier 6 and a second amplifier 8 which is coupled to an output 10 of the first amplifier 6 such that the first and second amplifiers 6 and 8 form an amplifier chain which is, in terms of the amplification of a radio frequency (RF) signal, also called RF-pallet.

The first amplifier 6 is powered from a first power supply 12 by a first energy supply signal 14 and the second amplifier 8 is powered from a second power supply 16 by a second energy supply signal 18. That is, the amplifiers 6 and 8 are connected in series such that a signal provided to the amplifier circuit 4 at its input 34 is first amplified by the first amplifier 6 and the so pre-amplified signal is, via an output 10 of the first amplifier 6, fed to an input of the second amplifier 8 such as to be amplified further and to provide an output signal an output 26 of the amplifier circuit 4. The amplifiers 6 and 8 may, for example, be voltage amplifiers which amplify a voltage change at their inputs, respectively. This may, for example, be achieved by transistors in common-emitter configuration or in common-source configuration. That is, power supplies 12 and 16 may provide a constant voltage as an energy supply signal to the amplifiers 6 and 8, as an example. Further embodiments of the present invention may use other signal configurations as energy supply signals, for example, providing a constant current as an energy supply for the amplifiers 6 and 8. Generally speaking, an energy supply signal may be understood as any kind of signal which is appropriate and utilized to provide the energy needed for the amplifiers 6 and 8 to operate. Although shown as separate devices in Fig. 1, the individually controllable power supplies 12 and 16 may in some embodiments also be integrated in a common housing or in a common integrated circuit (IC) on a common die or the like.

The controller 2 comprises a monitoring interface 20 operable to receive monitoring information indicative of a signal characteristic of a signal amplified by the amplifier circuit. That is, the monitoring information may, without demand for completeness, comprise any single information of or a combination of any of the following informations: a power dissipation of the first and/or the second power supply, a power dissipation of the first and/or the second amplifier, an information on a modulation characteristic of a signal provided to the amplifier circuit 4 at its input 34, a current drawn by the first amplifier 6 and/or the second amplifier 8 from the associated power supplies 12 and 16, a signal to average ratio of the signal provided to the amplifier circuit 4 at its input 34, a power of the signal as provided at the output 10 of the first amplifier or a power of the output signal at the output 26. As indicated by Fig. 1, the particular embodiment of Fig. 1 utilizes DC-DC converters as power supplies 12 and 16, that is the power supply signals 14 and 18 are constant voltage signals provided to the amplifiers 6 and 8.

The controller 2 further comprises a control interface 22 which is operable to provide a control signal 24 depending on the monitoring information. The control signal 24 is operable to modify a characteristic of at least one energy supply signal of the group of the first energy supply signal 14 and the second energy supply signal 18 such that a power efficiency of the amplifier circuit 4 is increased. To this end, the control interface 22 is connected with the first and second power supplies 12 and 16. While the connection is indicated as a wired connection in Fig. 1, it goes without saying that further embodiments will also utilize wireless connections or any other kind of information exchange mechanism. Furthermore, although the monitoring interface 20 and the control interface 22 are shown to utilize different connections in order to receive or transmit the information, alternative embodiments may utilize one and the same physical connection or physical data link in order to exchange the associated information.

Fig. 2 shows a power characteristic of two typical DC-DC converters that convert a constant supply voltage to a different, lower voltage.

Fig. 2 shows, on the X-axis 32, the current drawn from a DC-DC converter at a given output voltage, while the Y-axis shows the power efficiency of the DC-DC converter in the present condition. At a maximum current Imax, to which the DC-DC converter is designed, the power efficiency of the DC-DC converters is the maximum achievable. With decreasing current drawn from the DC-DC converters, the efficiency drops significantly, e.g. to less than 70% at one quarter of the maximum current. Generally speaking, the power efficiency of the DC-DC power supplies 12 and 16 is higher in a first operating range 28, while in a second operating range 30, the power efficiency is lower.

The first operating range 28 corresponds to a first interval of a further characteristic of the energy supply signal which is to a first interval of the current drawn from the DC-DC converters. The first graph 36 shows the efficiency curve for a first embodiment of a DC-DC converter, the second graph 38 shows the efficiency curve of a more recent digitally controllable DC-DC converter which is capable of adjusting its DC- output in response to a digital control signal while in operation. While the absolute values of the efficiency may differ, the general behavior of the power supplies or DC-DC converters in Fig. 2 are identical in that the power supplies are operated with a higher power efficiency in the first operating range 28 while they are operating at a lower efficiency in the second operating range 30.

Depending on the information of the signal characteristic of a signal amplified by the amplifier, the controller 2 provides a control signal 24 at its control interface 22 such as to, for example, increase the overall power efficiency of the amplifier circuit 4. To this end, the characteristic, i.e. the voltage, of the second power supply 16 may be modified such that the second power supply 16 operates in the first operating range 28 with high efficiency while the voltage of the first power supply signal 14 is modified such that the first power supply 12 operates in the second operating range 30 with lower efficiency. This is achieved by lowering the voltage provided by the first power supply 12 and raising the voltage provided by the second power supply 16. Since the second power supply 16 serves to provide the larger amount of energy for the operation of the second amplifier 8 which is the output amplifier of the chain, the change of the operating points may result in an overall increase of power efficiency of the amplifier circuit 4 at the given signal conditions.

The controller 2 may, as indicated in Fig. 1, be implemented as an additional hardware, for example as an FPGA, or be implemented in already existing control logic, for example in the control logic used to steer or operate the power supplies 12 and 16.

It goes without saying that a single controller 2 as indicated in Fig. 1 may also serve to control the operating characteristic of multiple amplifier circuits 4 at a time, e.g. within a mobile base station transceiver serving multiple antennas.

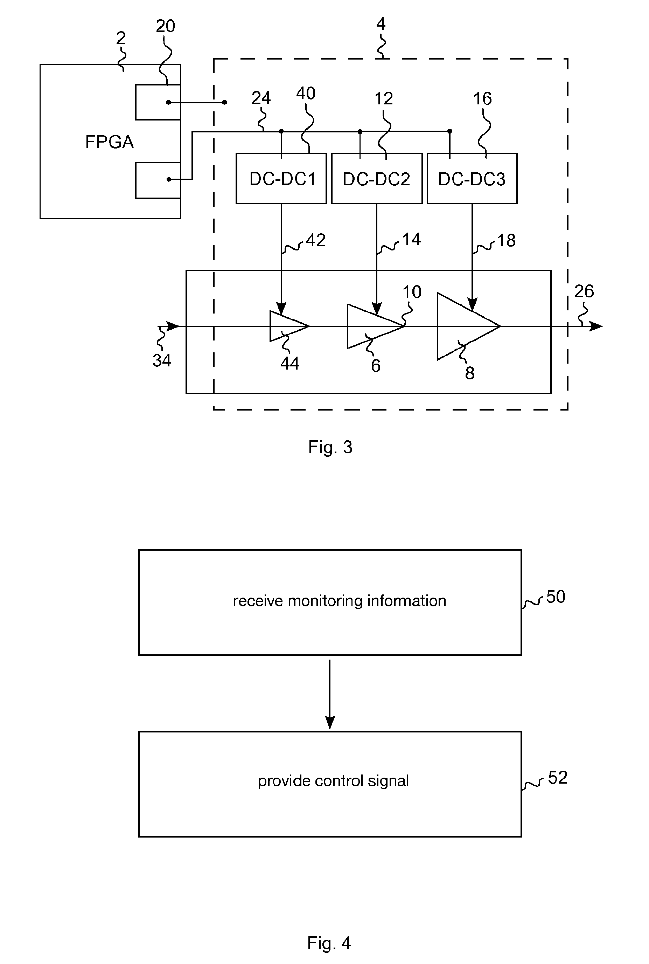

Fig. 3 shows a further embodiment of a controller 2 for controlling an operating characteristic of an amplifier circuit 4, which corresponds mainly to the embodiment already discussed with respect to Fig. 1. In addition to the first and second amplifiers 6 and 8, the embodiment shown in Fig. 3 further comprises a third amplifier 44 serving as an input amplifier for the signal provided to the amplifier circuit at its input 34. That is, an output of the third amplifier 44 is coupled to an input of the amplifier 6 such that the signal pre-amplified by the third amplifier 44 is input as an input signal to the first amplifier 6. The third amplifier 44 is energized from a third power supply 40, providing a third energy supply signal 42 to energize the third amplifier 44. In short, the amplifier circuit 4 of Fig. 3 differs from the amplifier circuit 4 of Fig. 1 in that an additional amplifier is used in the RF-pallet, that is, the amplifier chain comprises three instead of two amplifiers. It goes without saying that alternative embodiments of controllers 2 for controlling an operating characteristic of an amplifier circuit 4 may be adapted to control amplifier circuits having arbitrary numbers of amplifiers connected in series or in parallel or in combinations thereof.

In other words, Fig. 3 shows an embodiment of an RF-pallet using DC-DC converters which have an efficiency that dramatically drops when they operate at lower output current. The arrangement of the power supply units 12, 16 and 40 and the associated amplifiers 6, 8 and 44 is controlled by an FPGA, which implements a controller 2 according to an embodiment of the present invention. The DC-DC converters shown in Fig. 3 are digitally controllable such as to be able to change their output voltages while under load and in operation. The controller FPGA 2 is utilized to dynamically adapt the output voltages of the power supply units 12, 16 and 40 and hence the input currents of each radio frequency amplifier stage, that is, the currents drawn by each of the amplifiers 6, 8 and 44. Each internal configuration (parameters and coefficients) of each DC-DC entity can be reprogrammed by the FPGA for the best overall power supply efficiency at the given load. A power supply unit comprising the power supplies 12, 16 and 40 may encompass single-phase and multi-phase DC-DC converters, which may also be implemented on, at least, one Integrated Circuit (IC).

For example, digital Pulse Width Modulation controllers (PWM) may be used which contain three DC-DC converters that are connected to the drain terminals of each of the radio frequency amplifiers 6, 8 and 44 of the amplification chain.

DC-DC converters 12 and 16 may be single-phase DC-DC controllers which are implemented with one of the digital PWM channels of an integrated circuit device. Since DC-DC converter 16 delivers the largest amount of currents since it is placed at the output stages' drain terminal (that is, DC-DC converter 16 energizes the second amplifier 8), it may be implemented in a multi-phase DC-DC topology (e.g. 3-4 phases). Each of the phase-branches may implement current sharing control in order to deliver the amount of output current, to provide little output voltage ripple and to target the best reachable DC-DC efficiencies, as for example efficiencies up to 96 %.

All DC-DCs can be reconfigured on-line via the controller utilizing, for example, a Power Management Bus (PMB). This may be utilized first to adapt the output current in respect to the traffic and, furthermore, to change accordingly the parameters of the DC-DC converters for the best suitable configuration at lower output current requirements (as for example switching time, bedtime switching, phase management, zeros and poles coefficients of the regulation loops, and so on).

Furthermore, all DC-DC entities or power supplies may be synchronized in order to be compliant with electromagnetic compatibility requirements.

The FPGA may monitor the instantaneous efficiency of the RF-pallet in real time, thus allowing various kinds of voltage sequencing of the power supplies 40, 12 and 16 in order to provide for an output signal 26 maintaining the desired power or containing the desirable energy.

Fig. 4 shows a schematic view of a flow diagram illustrating an embodiment of a method for controlling an operating characteristic of an amplifier circuit comprising at least a first amplifier and a second amplifier coupled to an output of the first amplifier, wherein the first amplifier is powered from a first power supply by a first energy supply signal and a second amplifier is powered from a second power supply by a second energy supply signal. In a receiving step 50, monitoring information indicative of a signal characteristic of a signal amplified by the amplifier circuit is received. In a providing step 52, a control signal is provided depending on the monitoring information, the control signal being operable to modify a characteristic of at least one energy supply signal of the group of the first energy supply signal and the second energy supply signal such that a power efficiency of the amplifier circuit is increased.

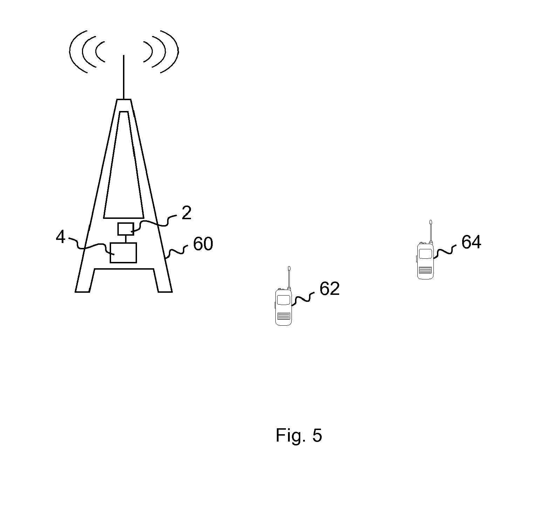

Fig. 5 shows, in a simplified sketch, a base station transceiver 60 of a mobile communications system which serves to communicate with mobile handsets 62 and 64, which are illustrated as a particular example for a user equipment.

The base station transceiver 60 utilizes an amplifier circuit 4 to amplify the radio frequency signal from a low power representation to a radio frequency signal that can be provided to an antenna system in order to be transmitted over the air. In order to save energy and to increase the power efficiency of the amplifier circuit 4, the base station transceiver furthermore comprises a controller 2 according to one of the embodiments of the present invention. The controller 2 may be implemented as an additional hardware or, alternatively, also be implemented in software running on the mobile base station transceiver. In one particular embodiment, the controller 2 may conclude on the required configuration of the power supplies and the amplifiers, that is on the appropriate control signal, by only utilizing information on an amount of data sent by the base station via the signal amplified by the amplifier circuit, thus allowing to increase the power efficiency without costly computations and additional hardware used to sense individual signal characteristics or signal conditions within the amplifier chain.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. A controller (2) for controlling an operating characteristic of an amplifier circuit (4) comprising at least a first amplifier (6) and a second amplifier (8) coupled to an output (10) of the first amplifier (6), wherein the first amplifier (6) is powered from a first power supply (12) by a first energy supply signal (14) and the second amplifier (8) is powered from a second power supply (16) by a second energy supply signal (18), the controller comprising:
a monitoring interface (20) operable to receive monitoring information indicative of a signal characteristic of a signal amplified by the amplifier circuit; and
a control interface (22) operable to provide a control signal (24) depending on the monitoring information, the control signal (24) being operable to modify a characteristic of at least one energy supply signal of the group of the first energy supply signal (14) and the second energy supply signal (18) such that a power efficiency of the amplifier circuit (4) is increased.

2. The controller of claim 1, wherein the control signal is provided such that a combined power efficiency of the first and the second power supply (12, 16) is increased.

3. The controller of claim 1, wherein the control signal (24) is provided such that a power of an output signal (26) provided by the amplifier circuit (4) is maintained.

4. The controller of claim 1, wherein the control signal (24) is operable to modify a voltage or a current of the at least one energy supply signal (14, 18).

5. The controller of claim 4, wherein the control signal (24) is operable to lower the voltage provided by the first power supply (12) and to raise the voltage provided by the second power supply (16).

6. The controller of claim 1, wherein each power supply (12, 16) is operable to operate in a first operating range (28) at a higher power efficiency and in a second operation range (30) at a lower power efficiency, the first operating range (28) corresponding to a first interval of a further characteristic (32) of the energy supply signal (14, 18) and the second operation range (30) corresponding to a different second interval of the further characteristic (32) of the energy supply signal; wherein
the control signal (24) is operable to modify the characteristic of the first energy supply signal (14) and the second energy supply signal (18) such that one power supply of the group of the first power supply (12) and the second power supply (16) operates in the first operation range (28) whereas the other power supply of the group operates in the second operation range (30) so that a total power efficiency of the amplifier circuit (4) is increased.

7. The controller of claim 6, wherein the further signal characteristic (32) is a current of the energy supply signal (14, 18) and wherein the control signal (24) is operable to modify the first energy supply signal (14) such that the first power supply (12) operates in the second operating range (30) and to modify the second energy supply signal (18) such that the second power supply (16) operates in the first operating range (28).

8. The controller of claim 1, wherein the monitoring information comprises at least one information of a power dissipation of the first and/or the second power supply (12, 16) and/or a power dissipation of the first and/or the second amplifier (6, 8) and/or an information on a modulation characteristic of a signal provided to the amplifier circuit at its input (34).

9. Method for controlling an operating characteristic of an amplifier circuit (4) comprising at least a first amplifier (12) and a second amplifier (16) coupled to an output (10) of the first amplifier (6), wherein the first amplifier (6) is powered by a first power supply (12) via a first energy supply signal (14) and the second amplifier (8) is powered by a second power supply (16) via a second energy supply signal (18), the method comprising:
receiving monitoring information indicative of a signal characteristic of a signal amplified by the amplifier circuit; and
providing a control signal (24) depending on the monitoring information, the control signal (24) being operable to modify a characteristic of at least one energy supply signal of the group of the first energy supply signal (14) and the second energy supply signal (18) such that a power efficiency of the amplifier circuit (4) is increased.

10. The method of claim 9, wherein the control signal (24) is provided such that a combined efficiency of the first and the second power supply (12, 16) is increased.

11. Amplifier stage, comprising:
a first amplifier (6) powered by a first energy supply signal (14) of a first power supply (12);
a second amplifier (8) having an input coupled to an output (10) of the first amplifier (6), the second amplifier (8) being powered by a second energy supply signal (18) of a second power supply (16); and
a controller (2) according to claim 1.

12. Amplifier stage according to claim 11, wherein the first and second power supplies (12, 16) comprise digitally controllable voltage converters, the digitally controllable voltage converters being operable to change their output voltages in response to a digital control signal of the controller (2).

13. Base Station transceiver for a base station of a mobile communications system, the base station transceiver comprising a radio frequency amplifier having an amplifier stage according to claim 11.

14. Base station transceiver according to claim 13, wherein the monitoring information of the controller comprises information on an amount of data sent by the base station via the signal amplified by the amplifier circuit.

15. A computer program having a program code for performing the method of claim 9, when the computer program is executed on a computer or processor.
